# EUROPEAN PATENT APPLICATION

(11) **EP 4 571 840 A1**
(43) Date of publication of application: **18.06.2025**
(21) Application number: 23216053.1
(22) Date of filing: 12.12.2023
(51) Int. Cl.: H01L 29/08, H01L 21/02, H01L 21/338, H01L 29/778, H01L 29/20, H01L 29/10, H01L 29/423

(54) **SEMICONDUCTOR SUBSTRATE AND METHOD OF FORMING A N-DOPED GROUP III NITRIDE CONTACT**

(71) Applicant: Infineon Technologies Austria AG, 9500 Villach (AT)
(72) Inventor: OSTERMAIER, Clemens, 9500 Villach (AT); JAMNIG, Andreas, 9500 Villach (AT); KNUUTTILA, Lauri Olavi, 9500 Villach (AT)
(74) Representative: Infineon Patent Department

(57) **Abstract**

In an embodiment, a semiconductor substrate is provided that comprises a multilayer Group III nitride substrate comprising a first major surface and at least one heterojunction that is capable of supporting a two-dimensional charge gas, at least one contact comprising a contact trench extending into the multilayer Group III nitride substrate from the first major surface. The contact trench is filled with n-doped Group III nitride material for forming an electrical connection to the two-dimensional charge gas. The semiconductor substrate further comprises at least one dummy trench extending into the multilayer Group III nitride substrate from the first major surface. The dummy trench is partially filled with n-doped Group III nitride material. The dummy trench has a width B and the contact trench has a width b, wherein B ≥ 1.1b.

## Description

### BACKGROUND

To date, transistors used in power electronic applications have typically been fabricated with silicon (Si) semiconductor materials. Common transistor devices for power applications include Si CoolMOSO, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times.

WO 2021/236311 A1 describes ohmic contacts for a multiple channel FET (Field Effect Transistor). In an embodiment, the ohmic contact comprises a plurality of slit-shaped recesses in a wafer on which a multiple channel FET resides, with each recess having a depth at least equal to the depth of the lowermost channel layer. Ohmic metals in and on the sidewalls of each recess provide ohmic contact to each of the multiple channel layers. Also described is the use of a regrown material to make ohmic contact with multiple channels, with the regrown material preferably having a corrugated structure.

### SUMMARY

In an embodiment, a semiconductor substrate comprises a multilayer Group III nitride substrate comprising a first major surface and at least one heterojunction that is capable of supporting a two-dimensional charge gas, at least one contact comprising a contact trench extending into the multilayer Group III nitride substrate from the first major surface, the contact trench being filled with n-doped Group III nitride material for forming an electrical connection to the two-dimensional charge gas and at least one dummy trench extending into the multilayer Group III nitride substrate from the first major surface, the dummy trench being partially filled with n-doped Group III nitride material. The dummy trench has a width B and the contact trench has a width b, wherein B ≥ 1.1b.

In an embodiment, a method of forming a n-doped Group III nitride contact is provided. The method comprises forming at least one contact trench and at least one dummy trench in a first major surface of a multilayer Group III nitride substrate comprising at least one heterojunction that is capable of supporting a two-dimensional charge gas, wherein the dummy trench has a width B that is greater than a width b of the contact trench, and growing n-doped Group III nitride material and filling the contact trench to form a contact and partially filling the dummy trench.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a semiconductor substrate according to an embodiment.
Figure 2 illustrates a cross-sectional view of a semiconductor substrate according to an embodiment.
Figure 3 illustrates a cross-sectional view of a semiconductor substrate according to an embodiment.
Figure 4 illustrates a cross-sectional view of a semiconductor substrate according to an embodiment.
Figure 5 illustrates a top view of a portion of a semiconductor substrate according to an embodiment.
Figure 6 illustrates five possible growth modes of n-doped Group III nitride material on a substrate.
Figure 7 illustrates a cross-sectional view of a HEMT according to an embodiment that is formed in a semiconductor substrate.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. The terms "Aluminum gallium nitride" and "AlGaN" each refer to a ternary alloy described by the formula AlₓGa₍₁₋ₓ₎N, where 0 < x < 1.

The present disclosure describes a method to fabricate a contact in a trench by filling the trench with n-doped Group III nitride material, e.g. n-doped GaN to form an nGaN plug during regrowth, whereby the nGaN plug provides a n-type contact. The nGaN plug may be used to form an n-type contact to a two-dimensional charge gas that forms the channel of a Group III nitride-based device such as a transistor device, e.g. a HEMT, or a bidirectional switch. The contact may be used for multi-channel devices which comprise multiple 2DEGs that are vertically stacked and which require a vertical ohmic connection path and an electrical connection to each of the 2DEGs arranged in the vertical stack.

Two designs for a contact for such multi-2DEG devices include a slanted trench that is filled with metal, for example a Ti/Al stack which is alloyed and a steep trench that is filled with n-type GaN, e.g. Si doped GaN. The slanted trench, however, occupies an increased area. The steep trench has a higher aspect ratio and occupies less area and has a depth which is, for example, greater than 300 nm.

Given the geometry of the trench, i.e. the high aspect ratio, filling the trenches to form the contact or plug has some challenges. For example, the growth of the n-doped GaN on the side wall of the trench has a tendency to be not conformal. For GaN with Si doping, no, little or only very slight growth tends to occur on the sidewall of the trench and in the trench itself. The material tends instead to be deposited on the top of the non-recessed area, i.e. the lateral planar surface adjacent the opening. This growth behaviour is in contrast to that observed for p-doped GaN, e.g. GaN doped with Mg, which has a very high lateral growth rate and a lower vertical growth rate so that thicker layers, e.g. at least ten-times thicker, can be found on the lateral extension of the plug wall, following different facets that favor deposition.

It has also been observed that filling of narrower trenches with n-doped GaN leads to fewer unwanted growth structures and a trench that is filled with n-doped GaN, whereas the use of larger features e.g. wider trenches or open areas, tends to lead to areas without favorable growth facets and create a region of irregular and arbitrary deposition. For example, random facets are selected by the incoming material stream, often forming high structural elements that are not desired.

In order to avoid unwanted growth structures and to uniformly fill a trench, in particular a contact trench with a depth of at least 300 nm, with n-doped Group III nitride material, it is proposed to include one or more dummy trenches in the substrate in addition to the trenches having predetermined locations and sizes for the contacts. The dummy trenches are, however, wider than the contact trenches and are only partially filled with the n-doped Group III nitride material. The n-doped GaN material that cannot be deposited in the contact trench by diffusion on the planar surface and which may otherwise grow into arbitrary unwanted 3D shapes on the planar surface is deposited into the sacrificial or dummy trenches that surround the main trench. The dummy trenches hinder the formation of undesirable vertical structures on the planar surface and edges of the opening of the contact trench and encourage the contact trench to be completed filled by the n-doped Group III material.

In some embodiments, a large number of dummy trenches is provided whereby the dummy trenches each have a length, the length of the various dummy trenches may extend in different directions. This arrangement of the dummy trenches may be used to avoid dummy trenches extending through the majority or even entire wafer, which may lead to crack building or breakage of the wafer.

A suitable area ratio of dummy trenches in relation to the area of the contact trenches may be selected such that the complete filling of the contact trenches is achieved and the topology of the deposited n-doped Group III nitride material in the sacrificial structures, i.e. the dummy trenches, is limited so that the dummy trenches are only partially filled with the n-doped Group III nitride material.

From a viewpoint of a achieving a good filling of trenches and limiting the topology in the sacrificial structures a total number of dummy trenches and contact trenches is determined by a ratio of an average deposition thickness on the free surface of the substrate and a deposition thickness within the trenches.

Additionally, setting an average nearest neighbouring distance between two trenches of the dummy trenches and the contact trenches to not more than twice the surface diffusion length during epitaxial growth of the n-doped Group III nitride material may be beneficial in this respect.

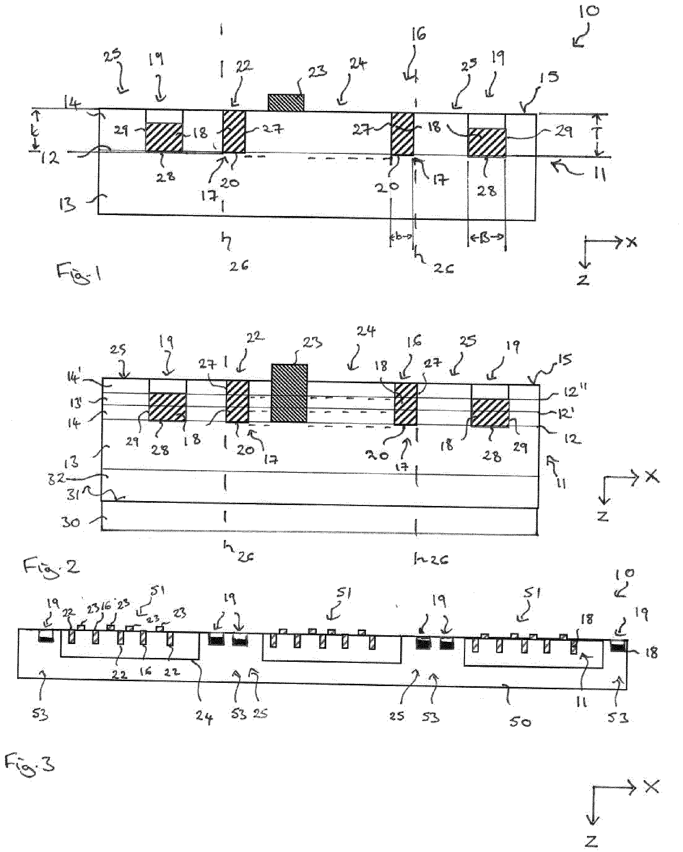

Figure 1 illustrates a cross-sectional view of a semiconductor substrate 10 according to an embodiment. The semiconductor substrate 10 comprises a multilayer Group III nitride substrate 11 which includes a heterojunction 12 which is capable of supporting a two-dimensional charge carrier gas such as a two-dimensional electron gas (2DEG). The 2DEG is shown schematically in the figures by a dashed line. The heterojunction 12 is formed between a first Group III nitride layer 13 and second Group III nitride layer 14 which have different compositions and differing bandgaps. The first Group III nitride layer 13 is formed of gallium nitride (GaN) and the second Group III nitride layer 14, which is located on the top of the first Group III nitride layer 13, is formed of AlGaN (aluminium gallium nitride having the composition described by the formula AlₓGa₍₁₋ₓ₎N, where 0 < x < 1). The multilayer Group the nitride substrate 11 has a first major surface 15 which is formed by the AlGaN layer 14.

The first and second Group III nitride layers 13, 14 are epitaxial layers which may be formed by epitaxial growth on a base substrate which is not illustrated in figure 1. The semiconductor substrate 10 includes least one electrically conductive contact 16 which comprises a contact trench 17 which extends into the multilayer Group III nitride substrate 11 from the first major surface 15. The contact trench 17 has a base 20 and a side wall 27 which extends from the base 20 to the first major surface 15. The side wall 27 may extend substantially perpendicular to the first major surface 15. The contact trench 17 is filled with an n-doped Group III nitride material 18 which forms an electrical connection to the two-dimensional charge carrier gas formed at the heterojunction 12.

In some embodiments, the contact trench 17 has a depth such that it is in contact with the lower Group III nitride layer 13. In some embodiments, the base of the trench 17 is formed by the fist Group III nitride layer 13. In some embodiments, contact trench 17 extends through the heterojunction 12. The n-doped Group III nitride material 18 located within the trench 17 is in contact with the heterojunction 12 and with the two-dimensional charge gas and forms the electrically conductive contact 16 within the trench 17.

The semiconductor substrate 10 further comprises at least one dummy trench 19 which extends into the multilayer Group III nitride substrate 11 from the first major surface 15. The dummy trench 19 has a base 28 and a side wall 29 that extends from the base 28 to the first major surface 15. The dummy trench 19 is partially filled with n-doped Group III nitride material 18. For example, the base 28 and lower portion of the dummy trench 19 may be filled with n-doped Group III nitride material 20, whereas the upper portion of the dummy trench 19, which is located vertically adjacent the first major surface 15, remains unoccupied by the n-doped Group III nitride material 20. The n-doped Group III nitride material 18 may be n-doped GaN, such as Si-doped GaN for example.

The contact trench 17 and the dummy trench 19 are distinguishable from one another by not only the degree to which they are filled with n-doped Group III nitride material 18 but also in their width. The dummy trench has a width B and the contact trench has a width b, whereby the width B of the dummy trench 19 is greater than the width b of the contact trench 17. As used herein, greater means that the width B of the dummy trench 19 is greater or equal to 1.1 times the width b of contact trench 17. Therefore, the difference between the widths B and b is greater than that arising from processing variations. In some embodiments, B greater or equal to 1.15xb, or greater or equal to 1.2xb.

The contact trench 17 and the contact 16 formed therein are elongate stripe -like and have a length which extends parallel to the first major surface 15. The length is used herein to denote the longest dimension of the trench 17. The contact trench 17 may be substantially rectangular in plan view and comprise four sidewall sections, whereby adjoining sidewall sections extend substantially perpendicularly to one another. The length of the contact trench 17 is greater than the width b, the width b extending in orthogonal to the length and parallel to the first major surface 15. The length is also greater than the depth t of the trench 17. The depth t is measured perpendicularly to the first major surface 15 and is 300 nm or more. Similarly, the dummy trench 19 is elongated and stripe -like and has a length (longest dimension) which extends parallel to the first major surface 15 which is greater than its width B. The width extends orthogonally to the length and parallel to the first major surface 15. The length of the dummy trench 19 is also greater than its depth T, the depth being measured perpendicularly to the first major surface 15. Using the Cartesian coordinate system, in the cross-sectional view of figure 1, the length of the contact trench 17 and of the dummy trench 19 extends into the plane of the drawing in the Y direction, the width b; B extends in the X direction and the depth in the Z direction.

In some embodiments, the contact trench has a depth/width ratio (t/b) that is at least 2:1 and the dummy trench has a depth/width ratio (T/B) that is less than 2:1, B may be ≥ 1.1 µm, and/or 0.3 µm ≤ b ≤ 1.0 µm, preferably 0.6 µm ≤ b ≤ 0.8 µm and/or the contact trench 17 has a depth t, wherein t ≥ 300nm, preferably 0.3 µm ≤ t ≤ 1 µm. The depth T of the dummy trench 19 may be less than 300 nm or T ≥ 300nm, preferably 0.3 µm ≤ T ≤ 1 µm. The depth T of the dummy trench 19may depend on its location in either the active device area or non-device area of the substrate.

The contact 16 may form part of a semiconductor device formed in and/or on the multilayer Group III nitride substrate 11. In the embodiment illustrated in figure 1, the contact 16 forms part of a transistor device, in particular a HEMT (High Electron Mobility Transistor) device 21 that further comprises a second contact 22 which has the same structure as the contact 16 and a gate 23 which is arranged laterally between the two contacts 16, 22. The second contact 22 comprises a contact trench 17 which is filled with n-doped Group III nitride material 18. The first contact 16 may provide the drain contact and the second contact 22 the source contact of the transistor device 21. The first Group III nitride layer 13 provides the channel layer and the second Group III nitride layer 14 the barrier layer of the HEMT, whereby the channel layer 13 may be formed of GaN and the barrier layer 14 may be formed of AlGaN.

In the embodiment illustrated in figure 1, the gate 23 is located on the first major surface 15. The gate electrode 23 may be have an elongate stripe -like structure and extend substantially parallel to the length of the source contact 22 and drain contact 16.

The gate 23 may comprise a gate electrode 33 formed of a gate metal which is located on the first major surface 15. In other embodiments, the gate 23 may be an insulated gate 23. In other embodiments, the gate 23 includes a p doped Group III nitride layer which is positioned between a gate metal layer 33 and the first major surface 15. In some embodiments, the gate 23 comprises a recessed gate structure comprising a recess formed in the first major surface 15 such that the AlGaN barrier layer 14 has a reduced thickness in a region directly under the gate 23 compared to the thickness in regions laterally adjacent the gate 23, i.e. laterally between the gate 23 and the source contact 16 and the gate 23 and laterally between the gate 23 and the drain contact 22, in the so-called access regions. In some embodiments, the gate recess may comprise p-doped Group III nitride material. The transistor device, e.g. HEMT, may be a depletion mode or enhancement mode device.

The transistor device 21 is positioned within an active device area 24 of the semiconductor substrate 10. The active device area 24 may comprise a plurality of transistor cells which are electrically coupled in parallel, each transistor cell comprising a source contact 22, gate 23 and drain contact 16. One or both of the source contact 22 and drain contact 16 may be common to adjacent ones of the transistor cells to form a pattern of source gate drain gate source gate drain. The semiconductor substrate 10 further comprises one or more non-device areas 25 which are arranged laterally adjacent the active device area 24. The lateral extent of the active device area 24 is indicated in figure 1 by a dashed line 26. In some embodiments, such as that illustrated in figure 1, the one or more dummy trenches 19 are located in the non-device areas 25 only.

In some embodiments, the semiconductor substrate 10 is a semiconductor die or chip and the active device area 24 is laterally surrounded by an edge termination region which provides the non-device area 25. The one or more dummy trenches 19 may be located in the edge termination region only. In other embodiments, the one or more dummy trenches 19 are located in the active device area 24 only or in both the active device area 24 and in the non-device area 25.

The n-doped Group III nitride contacts 16, 22 may be fabricated by forming a contact trench 17 for each contact and at least one dummy trench 19 in a first major surface 15 of the multilayer Group III nitride substrate 11 that comprises at least one heterojunction 12 that is capable of supporting a two-dimensional charge gas. The dummy trench 19 has a width B that is greater than a width b of the contact trench 17, whereby B ≥ 1.1b. The contact trenches 17 and dummy trenches 19 may be fabricated by etching. For example, a mask may be applied to the first major surface 15, structured to provide a plurality of opening, each opening being sized, shaped and located where a contact trench 17 or dummy trench is to be formed. An etching process, e.g. wet etching and/or plasma etching is carried out to remove portions of the Group III nitride substrate 11 that are exposed by the openings in the mask. n-doped Group III nitride material is grown, for example by MOPVE deposition of Si-doped GaN and the contact trench 17 is completely filled with the n-doped Group III nitride material 18 to form the respective contact 16, 22 so that the upper surface of the Group III nitride is coplanar with the first major surface 15 and the dummy trench 19 is partially filled with the n-doped Group III nitride 18 leaving the upper portion of the dummy trench 19 open and devoid of Group III nitride material 10.

The spacing between the dummy trench 19 and the contact trench 17 and/or the depth/width ratio of the individual dummy trenches 19 and/or the depth/width ratio of the individual contact trenches 17 is selected such that growth of the n-doped Group III nitride 18 on the first major surface 15 is hindered. This spacing between the dummy trench 19 and the contact trench 17 and/or the depth/width ratio of the dummy trench 19 and/or the depth/width ratio of the contact trench 17 may be selected by suitable location and structuring of the openings in the mask and conditions of the etch process used to remove material from the multilayer Group III nitride substrate 11.

In some embodiments, the method further comprises forming a metallization structure on the first surface 15. The metallization structure comprises an electrically conductive redistribution structure and one or more dielectric layers. The electrically conductive redistribution structure is electrically connected to the contacts 16, 22. However, the n-doped Group III nitride material 20 in the dummy trench 19 is electrically separate from the metallization structure. The dummy trench 19 and the n-doped Group III nitride material 18 in the dummy trench 19 may be electrically floating. For a transistor device, the metallization structure may electrically connect the source contacts 22 to a source pad, the drain contacts 16 to a drain pad and the gates 23 to a gate pad.

Figure 2 illustrates a cross-sectional view of a semiconductor substrate 10 according to an embodiment. The semiconductor substrate 10 comprises a multilayer Group III nitride substrate 11, first and second contacts 16, 22 with respective contact trenches 17 that are fully filled with n-doped Group III nitride material 18, a gate contact 23 and one or more dummy trenches 19 that are only partially filled with the n-doped Group III nitride 18 similar to the embodiment described with reference to and illustrated in figure 1. In figure 2, the base substrate 30 of the semiconductor device 10 is shown. The base substrate 30 comprises a growth surface 31 which is capable supporting the epitaxial growth of one or more Group III nitride layers. A Group III nitride buffer layer 32 is epitaxially grown on the growth surface 31 and the multilayer Group III nitride layer 11 is epitaxially grown on the Group III nitride buffer layer 32. The first Group III nitride layer 13 is epitaxially grown on the buffer layer 32 and the second Group III nitride layer 14 is epitaxially grown on the first Group III nitride layer 13.

In some embodiments, the base substrate 30 is a foreign substrate, i.e. is formed of a material other than Group III nitride materials and includes the upper or growth surface which is capable of supporting the epitaxial growth of one or more Group III nitride-based layers. The base substrate 30 may be formed of silicon and may be formed of monocrystalline silicon or an epitaxial silicon layer, for example, or may be formed of sapphire.

The buffer layer 32 comprises multiple Group III nitride sublayers that are epitaxially grown on the growth surface 31 of the base substrate 13. A typical transition or buffer structure for the buffer layer 32 of a silicon base substrate 30 includes a AIN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AlN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

In some non-illustrated embodiments, the Group III nitride-based semiconductor buffer layer 32 may further include a back barrier layer. The Group III nitride channel layer 13 is formed on the back barrier layer and forms a heterojunction with the back barrier layer and the Group III nitride barrier layer 14 is formed on channel layer 13. The back barrier layer has a different bandgap to the channel layer and may comprise AlGaN, for example. The composition of the AlGaN of the back barrier layer may differ from the composition of the AlGaN used for the barrier layer 14.

The semiconductor substrate 10 illustrated in figure 2 differs from that illustrated in figure 1, in that the multilayer Group III nitride substrate 11 comprises three heterojunctions 12, 12', 12" arranged in a vertical stack. This arrangement can be used to form a multi-channel HEMT. The Group III nitride multilayer substrate 11 includes two first Group III nitride layers 13, 13', both formed of GaN, and two second Group III nitride layers 14, 14' both formed of AlGaN that are arranged alternately in a stack. The first GaN layer 13 is formed on the buffer layer 32, first AlGaN layer 14 on the first GaN 13, the second GaN layer 13' on the first AlGaN layer 14 and the second AlGaN layer 14' on the second GaN layer 13'. A first heterojunction 12 is formed between the lowermost GaN layer 13 and the adjacent AlGaN layer 14, a second heterojunction 12' is formed between the GaN layer 13' and the underlying AlGaN layer 14 of the stack and a third heterojunction 12" is formed between the GaN layer 13' and the overlying AlGaN layer 14'. However, the Group III nitride layer 11 is not limited to comprising three heterojunctions to provide a multi-channel device but may include two or more than three heterojunctions by including an appropriate number of first and second Group III nitride layers arranged alternately in a vertical stack.

In this embodiment, the source contact 22 as well as the drain contact 16 and the gate 23 extend into the multilayer Group III nitride substrate 11 and may extend through all three heterojunctions 12, 12', 12" or may extend through the upper two heterojunction's 12', 12" and extend to the lowermost heterojunction 12. In this embodiment, the dummy trenches 19 are located in the edge termination region which provides the non-device area 25. The edge termination region laterally surrounds the active device area 24. However, one or more dummy trenches 19 may be arranged in the active device area 14 in addition to or in place of the dummy trenches 19 in the edge termination region.

Figure 3 illustrates a cross-sectional view of a semiconductor substrate 10 according to another embodiment. In this embodiment, the semiconductor substrate 10 is a semiconductor wafer 50 which comprises a plurality of component positions 51 which are laterally arranged in the first major surface 52 of the wafer 50. The component positions 51 are typically arranged in rows and columns to form a grid. Individual ones of the component positions 51 are spaced apart from one another by a non-device area 25 which may be a referred to as a saw street or kerf 53. In this embodiment, the individual ones of the component positions 51 provide individual active device areas 24.

In the embodiment illustrated in figure 3, the dummy trenches 19 are not positioned within the semiconductor device provided by the component position 51 but are solely located in the kerfs 53 and therefore outside of the component positions 51. When the component positions the semiconductor devices are singulated from the wafer 50 by dicing the wafer 50 along the kerf lines 53, the dummy trenches 19 are removed such that the remaining individual semiconductor dies, each formed from one of the component positions 51, do not include any dummy trenches. The dummy trenches 19 are only partially filled with the n-doped Group III nitride material 20, whereas the contacts 16, 22 within the component positions 51 are entirely filled with n-doped Group III nitride material.

In other embodiments, one or more dummy trenches 19 may be located in the kerf regions 53 and one or more dummy trenches 19 may be located within the component positions 51 and be present in the semiconductor die singulated from the wafer 50. In some embodiments, each component position 51 provides a transistor device, e.g. a HEMT device.

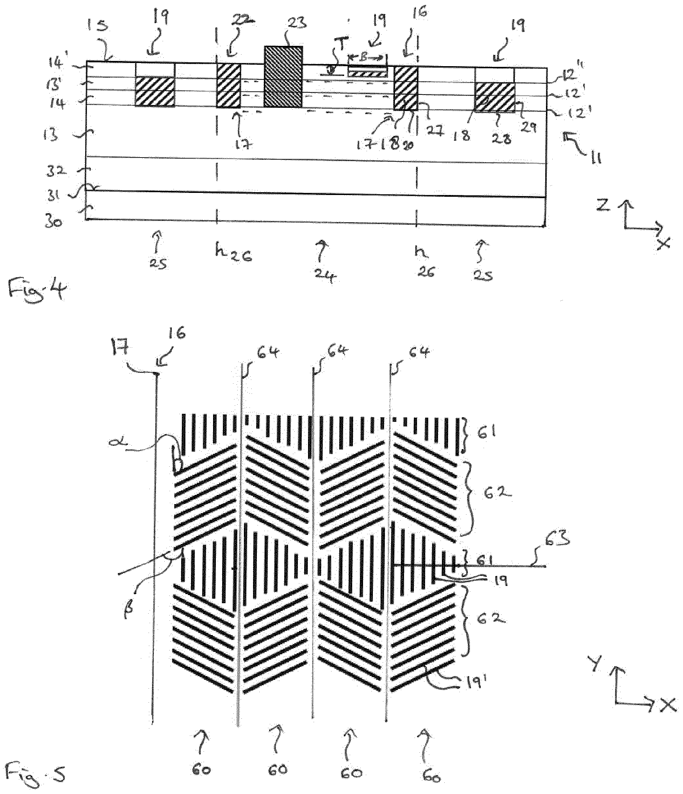

Figure 4 illustrates a cross-sectional view of a semiconductor substrate 10 according to an embodiment. The semiconductor substrate 10 differs from that illustrated in and described with reference to figure 2 in that, in this embodiment, at least one dummy trench 19, which is only partially filled with n-doped Group III nitride material, such that the upper portion which is arranged vertically adjacent to the first major surface 15 remains unfilled, is located within the active device area 24. In this embodiment, a transistor device is located in the active device area 24 and at least one the dummy trench 19 is located laterally between the gate 23 and the drain contact 16. The depth of the dummy trench 19 is less than the depth of the contacts 22, 16 such that the base 27 of the dummy trench 19 is located within the uppermost AlGaN layer 14' of the multiple Group III nitride layers of the Group III nitride substrate 11. In other words, the dummy trench 19' does not extend to or through the uppermost heterojunction 12" or any heterojunction 12' of the Group III nitride substrate 11. Two or more of the dummy trenches 19 may also be used and located within the active device area 24, for example at any position laterally between the source contact 22 and the gate 23 and/or laterally between the gate 23 and the drain contact 16.

In addition to the dummy trench 19 located within the active device area 24, as illustrated in figure 4, one or more dummy trenches 19 may also be located in the non-device areas 25. If the semiconductor substrate 10 is a semiconductor die, for example as illustrated in figure 4, the non-device area 25 may be the edge termination region and one or more dummy trenches 19 are arranged in the edge termination region.

If the semiconductor substrate 10 is a wafer 50 comprising a plurality of component positions 51, one or more dummy trenches 19 may be arranged in a non-device area 25, which may be provided by a kerf region 53 between the component positions 51 or the edge termination region within the component positions 51, and in the active device area 24 of the component position. One or more dummy trenches 19 may be located in the kerf region 53 and/or the edge termination region of the component positions 51 and in the active device area 24 of the component position.

Figure 5 illustrates a top view of a portion of a semiconductor substrate 10 and illustrates the layout of one contact 16 formed in a contact trench 17 and a plurality of dummy trenches 19. This layout may be used in any one of the semiconductor substrates described herein. The contact trench 17 and dummy trenches 19 each have a rectangular form in top view which is not shown in the layout of figure 5. The contact trench 17 comprises a trench formed in the first major surface 15 of the semiconductor substrate that is entirely filled with n-doped Group III nitride material 18 and the dummy trenches 19 are partially filled with n-doped Group III nitride material18.

The contact trench 17 has a length, i.e. longest dimension, that extends parallel to the first surface 15 of the semiconductor substrate 10 in the Y direction using the Cartesian coordinate system. The dummy trenches 19 also each have a length, i.e. longest dimension, that extends parallel to the first surface 15. The length of one or more of the dummy trenches 19 extends at an angle α to the length of the contact trench 17. In some embodiments, 0° < α ≤ 90° so that the dummy trench(es) 19 are non-parallel to the contact trench 17. In some embodiments, 30° < α ≤ 60° or α = 45°.In other embodiments, the length of one or more of the dummy trenches 19 extends parallel to the length of the contact trenches 17.

In embodiments, such as that illustrated in figure 5, the semiconductor substrate 10 comprises a plurality of dummy trenches 19 and the dummy trenches 19 are arranged in a regular pattern. The regular pattern comprises a plurality of rows 60 of dummy trenches 19, 19', a plurality of dummy trenches 19, 19' being arranged each row 60. The rows 60 extend substantially parallel to one another, for example in the Y direction and extend parallel to the length of the contact trench 17 that also extends in the Y direction. Neighboring rows 60, 60' of the pattern have a mirror symmetrical arrangement about a line 64 extending in the Y direction.

In some embodiments, within each row 60, the dummy trenches 19, 19' are divided into two or more groups 61, 62, each group 61, 62 having a different orientation, i.e. the length of the dummy trenches 19 arranged in a first group 61 extends in a non-parallel fashion to the length of the dummy trenches 19' arranged in a second group 61 of that row 60. The dummy trenches 19, 19' of a group 61, 62 extend substantially parallel to one another within the respective group 61, 62. The dummy trenches 19, 19' of neighbouring groups 60, 61 within a row 60 extend at an angle β to one another, wherein 0° < β ≤ 90°. In some embodiments, 30° < β ≤ 60° or β = 45°.

In the example of a regular pattern illustrated in figure 5, the length of the dummy trenches 19 of the first group 61 extend substantially parallel to one another and parallel to the length of the contact trench 17, i.e. in the Y direction. The length of the dummy trenches 19' of the second group 62 extend parallel to one another but at an angle α to the length of the contact trench 17, where α lies in the range of 0° < α ≤ 90°. In this particular embodiment α is around 60°. The two groups 61, 62 alternate within the row 60 in the Y direction. Neighboring second groups 62, 62' of a row have a symmetrical arrangement about a line 63 extending in the X direction though the first group 61 located between the two second groups 62, 62' of that row.

The dummy trenches 19' of the second group 62 have substantially the same length, whereas the dummy trenches 19 of the first group have differing lengths, the length increasing in the X direction towards the line 64. The spacing between each of the dummy trenches 19, 19' of a group 61, 62 and between the groups 61, 62 is a uniform as processing variations allow.

This regular pattern of dummy trenches 19, 19' may be repeated across some of or the entire area of the active device area 24 that is not occupied by features of the device, for example the contacts 16, 22, 23 of a transistor device and/or may be repeated across some or all of the non-active areas 25 of the substrate 10, e.g. the edge termination region of a semiconductor die or the kerf region of a wafer.

The contact trenches 17 have a width b that is less than the width B of the dummy trenches 19 so that B ≥ 1.1b. The dimensions of the contact trenches 17 and of the dummy trenches 19 of any one of the embodiments described herein may be set as followed. The contact trench may have a depth/width ratio (t/b) that is at least 2:1 and the dummy trench a depth/width ratio (T/B) that is less than 2:1. The width B of the dummy trench 19 may be ≥ 1.1 µm, and/or the width b of the contact trench 17, 22 may be within the range of 0.3 µm ≤ b ≤ 1.0 µm, preferably 0.6 µm ≤ b ≤ 0.8 µm. The contact trench 17, 22 may have a depth t, wherein 0.3 µm ≤ t ≤ 1 µm.

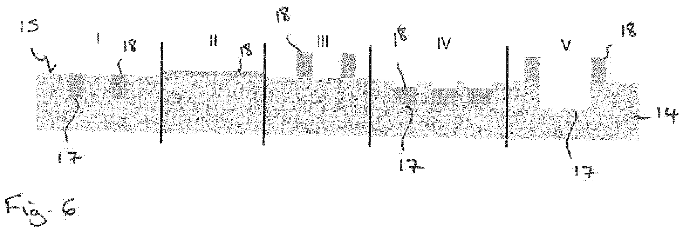

Figure 6 illustrates five possible growth modes of n-doped Group III nitride material 18, e.g. n-doped GaN, on a Group III nitride substrate, e.g. an AlGaN barrier layer 14 of a HEMT.

In Type I growth behaviour, there is a higher lateral growth rate that fills the trench 17 with minor growth on the planar surface 15 in which the trench 17 is formed. This type I growth behaviour is commonly seen for p-doped Group III nitride, e.g. p-doped GaN (GaN:Mg).

In Type II growth behaviour, blanket and uniform deposition of Group III nitride material 18 on the planar surface 15 is observed. Type II growth behaviour is commonly observed for unintentionally doped (UID) GaN and GaN:Mg in absence of trenches.

In Type III growth behaviour, there is favorable growth in the vertical or C-direction of Group III nitride material, i.e. perpendicular to the planar surface 15. Type III growth behaviour is commonly observed for n-doped Group III nitride material 18, e.g. GaN:Si and results in the formation of 3D vertical structures outside of the trench.

In Type IV growth behaviour, the trenches 17 are partially filled with Group III nitride material due to limited material available to fill the trenches 16.

In Type V growth behaviour, there is preferable growth on sidewall of trenches 17 but the trench 17 itself is not filled with Group III nitride material.

n-doped Group III nitride material, e.g. n-doped GaN, e.g. GaN:Si, has a strong tendency to follow growth behavior of Types III and V. Type V is observed for wider trenches and Type III in the absence of trenches. If the trenches are narrow enough, the trenches are filled with n-doped according to type I and IV growth behaviour. Type II growth behavior has not been observed for GaN:Si material with a relatively high Si content.

The present disclosure provides methods with which the fabrication of deep vertical n-doped GaN filled trenches is achieved by encouraging Type I growth behaviour. These fully filled trenches can be used to form n-doped GaN plugs which can be used as n-doped GaN contacts. The depth of the trench that can be entirely filled with n-doped GaN is at least 300 nm

A method to fill trenches with n-doped GaN (GaN:Si) material during a regrowth in which the main contact trench 17 is filled completely, similar to the Type I behaviour shown in figure 6, comprises forming and locating wider dummy trenches 19 laterally adjacent and around the narrower contact trench 17 formed in the first major surface 15. The n-doped GaN material 18 that cannot be deposited in the main contact trench 17 by diffusion on the planar surface 15 and which may otherwise grow into arbitrary 3D shapes on the planar surface 15, e.g. type III growth, is deposited into the sacrificial or dummy trenches 19 that surround the main contact trench 17. The dummy trenches 19 hinder the formation of undesirable vertical structures on the planar surface and edges of the opening of the contact trench 17 and encourage the narrower contact trench 17 to be completed filled by the n-doped Group III material 18. The dummy trenches 19 may be only partially filled with the nGaN as shown in figure 6 as Type IV behaviour. This type IV behavior in the dummy trenches 19 can be encouraged by the dummy trenches 19 having a greater width than the contact trench 17.

In some embodiments, a plurality of dummy trenches 19 is provided and the dummy trenches 19 are located over the entire die or wafer area that is not needed for actual trench filling, i.e. the contact trenches 17 for the source and drain contacts 22, 16 or other features of the semiconductor device. This sacrificial area may be extended to unused areas, i.e. the dummy trenches 19 may also be positioned in non-device areas 25 located laterally adjacent the active device area 14 and/or in kerf regions 53 separating component positions 51 of a wafer 50, for example.

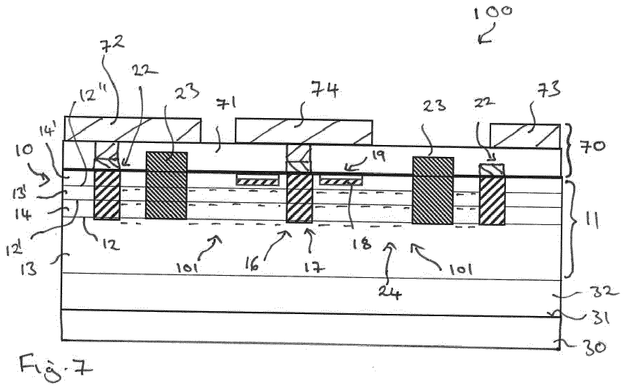

Figure 7 illustrates a cross-sectional view of a HEMT 100 that is formed in a semiconductor substrate 10 having a multilayer Group III nitride substrate 11 as shown in figure 4. Two transistor cells 101 are illustrated in figure 7 and each has an n-doped Group III nitride source contact 22, a gate contact 23 and a n-doped Group III nitride drain contact 16, whereby the n-doped Group III nitride drain contact 16 is common to neighbouring transistor cells 101. The n-doped Group III nitride source contact 22 and the n-doped Group III nitride drain contact 16 are each formed in a respective contact trench 17 which extends through the multiple stacked heterojunctions 12, 12', 12" of the multiplayer Group III nitride substrate 11 and which is filled with n-doped Group III nitride material 18. A plurality of dummy trenches 19 are provided which extend into the multilayer Group III nitride substrate 11 from the first major surface 15 and which are positioned in the active device area 24 of the HEMT 100 laterally adjacent to the drain contact 16. The dummy trenches 19 have a depth which is less than the thickness of the uppermost AlGaN layer 14'. The dummy trenches 19 are partially filled with Group III nitride material 18 leaving the upper portion of the trench free of Group III nitride material. The dummy trenches 19 have a greater width than the contact trenches 17 of the source 22 and drain contact 16. In the cross-sectional view of figure 7, one dummy trench 19 is shown in the access region between the drain contact 16 and gate 23 for each transistor cell 101. However, the arrangement is not limited to single dummy trench 19 for each transistor cell 101 but may also include two or more dummy trenches 19 in each transistor cell 101.

Figure 7 also illustrates a metallisation structure 70 which is located on the first major surface 15 and which includes one or more electrically insulating layers 71 and a source pad 72 which is electrically connected to the source contacts 22, a drain pad 73 which is electrically connected to the drain contact 16 and a gate pad 74 which is electrically connected to the gates 23. The dummy trenches 19 are electrically insulated from the conductive portions of the metallisation structure 70 by the electrically insulating layers 71 of the metallisation structure 70. Consequently, the n-doped Group III nitride material 18 within the dummy trenches 19 is electrically floating.

A metallization structure may also be included on the first major surface 15 of the semiconductor substrate 10 according to any one of the embodiments described herein, whereby the dummy trenches 19 and the n-doped Group III nitride material 18 therein is electrically separate from the metallization structure and may be electrically floating.

Although the present disclosure is not so limited, the following numbered examples demonstrate one or more aspects of the disclosure.

### Examples

Example 1. A semiconductor substrate, comprising
a multilayer Group III nitride substrate comprising a first major surface and at least one heterojunction that is capable of supporting a two-dimensional charge gas;
at least one contact comprising a contact trench extending into the multilayer Group III nitride substrate from the first major surface, the contact trench being filled with n-doped Group III nitride material for forming an electrical connection to the two-dimensional charge gas;
at least one dummy trench extending into the multilayer Group III nitride substrate from the first major surface, the dummy trench being partially filled with n-doped Group III nitride material,
wherein the dummy trench has a width B and the contact trench has a width b, wherein B ≥ 1.1b.

Example 2. A semiconductor substrate according to example 1, wherein the contact trench extends to or through the heterojunction.

Example 3. A semiconductor substrate according to example 1 or example 2, wherein the contact trench has a depth/width ratio (b/w) that is at least 2:1 and the dummy trench has a depth/width ratio (B/W) that is less than 2:1.

Example 4. A semiconductor substrate according to one of examples 1 to 3, wherein B ≥ 1.1 µm, and/or 0.3 µm ≤ b ≤ 1.0 µm, preferably 0.6 µm ≤ b ≤ 0.8 µm.

Example 5. A semiconductor substrate according to one of examples 1 to 4, wherein the contact trench has a depth t, wherein 0.3 µm ≤ t ≤ 1 µm.

Example 6. A semiconductor substrate according to one of examples 1 to 5, wherein the n-doped Group III nitride material comprises silicon dopants.

Example 7. A semiconductor substate according to one of examples 1 to 6, wherein a total number of said dummy trenches and said contact trenches is determined by a ratio of an average deposition thickness on the first major surface of the substrate and a deposition thickness within the dummy trenches and the contact trenches.

Example 8. A semiconductor substrate according to examples 1 to 7, wherein an average nearest neighbouring distance between two trenches of the dummy trenches and the contact trenches is not more than twice the surface diffusion length during epitaxial growth of the n-doped Group III nitride material.

Example 9. A semiconductor substrate according to one of examples 1 to 8, wherein the multilayer Group III nitride substrate comprises at least one active device area and at least one non-active area, wherein the at least one contact trench is arranged in the active device area and at least one of the dummy trenches is arranged in the non-active area and/or in the active device area.

Example 10. A semiconductor substrate according to example 9, wherein the semiconductor substrate is a semiconductor die having an active device region that is surrounded by an edge termination region that provides the non-device area, or the semiconductor substrate is a semiconductor wafer with a plurality of component positions that are separated by non-device areas.

Example 11. A semiconductor substrate according to any one of examples 1 to 10, wherein the at least one contact trench has a length that extends parallel to the first surface and the at least one dummy trenches has a length that extends parallel to the first surface, wherein the length of one or more of the dummy trenches extends at an angle α to the length of the contact trench, wherein 0° < α ≤ 90° and/or the length of one or more of the dummy trenches extends parallel to the length of the contact trenches.

Example 12. A semiconductor substrate according to example 11, wherein 30° < α ≤ 60° or α = 45°.

Example 13. A semiconductor substrate according to any one of examples 1 to 12, wherein the semiconductor substrate comprises a plurality of dummy trenches and the dummy trenches are arranged in a regular pattern.

Example 14. A semiconductor substrate according to example 13, wherein the regular pattern comprises a plurality of rows of dummy trenches that are divided into one or more groups, wherein the dummy trenches of a group extend substantially parallel to one another, wherein the dummy trenches of neighbouring groups extend at an angle β to one another, wherein 0° < β ≤ 90°.

Example 15. A semiconductor substrate according to example 14, wherein 30° < β ≤ 60° or β = 45°.

Example 16. A semiconductor substrate according to any one of examples 1 to 15, wherein the multilayer Group III nitride body comprises at least two heterojunctions arranged in a stack and the contact trench has a depth such that it extends through the at least two heterojunctions.

Example 17. A semiconductor substrate according to one of examples 1 to 16, wherein the multilayer Group III nitride body comprises a Group III nitride channel layer and a Group III nitride barrier layer that is arranged on the Group III nitride channel layer and forms a heterojunction therebetween.

Example 18. A semiconductor substrate according to example 17, wherein the Group III nitride channel layer comprises GaN and the Group III nitride barrier layer comprises AlGaN.

Example 19. A semiconductor substrate according to any one of examples 1 to 18, wherein the semiconductor substrate comprises two contacts that are spaced apart on the first major surface and a gate electrode that is arranged laterally between the two contacts to form a transistor device.

Example 20. A semiconductor substrate according to example 19, wherein the transistor device is a HEM (High Electron Mobility Transistor).

Example 21. A semiconductor substrate according to any one of examples 1 to 20, further comprising a metallization structure on the first surface that is electrically connected to the at least one contact, wherein the n-doped Group III nitride material in the at least one dummy trench is electrically separate from the metallization structure.

Example 22. A semiconductor device according to example 21, wherein the metallization structure provides a source pad, a drain pad and a gate pad and the at least one dummy trench is electrically floating.

Example 23. A method of forming a n-doped Group III nitride contact, the method comprising:
forming at least one contact trench and at least one dummy trench in a first major surface of a multilayer Group III nitride substrate comprising at least one heterojunction that is capable of supporting a two-dimensional charge gas, wherein the dummy trench has a width B that is greater than a width b of the contact trench;
growing n-doped Group III nitride material and filling the contact trench to form a contact and partially filling the dummy trench.

Example 24. A method according to example 23, wherein the spacing between the dummy trench and the contact trench and/or the depth/width ratio of the dummy trench and/or the depth/width ratio of the contact trench is selected such that growth of the Group III nitride on the first major surface is hindered.

Example 25. A method according to example 23 or example 24, wherein the contact trench has a depth/width ratio (b/w) that is at least 2:1 and the dummy trench has a depth/width ratio (B/W) that is less than 2:1.

Example 26. A method according to one of examples 23 to 25, wherein B ≥ 1.1 µm, and/or 0.3 µm ≤ b ≤ 1.0 µm, preferably 0.6 µm ≤ b ≤ 0.8 µm.

Example 27. A method according to one of examples 23 to 26, wherein the contact trench has a depth t, wherein 0.3 µm ≤ t ≤ 1 µm.

Example 28. A method according to one of examples 23 to 27, further comprising:
forming a metallization structure on the first surface that is electrically connected to the at least one contacts,
wherein the n-doped Group III nitride material in the dummy trench is electrically separate from the metallization structure.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor substrate, comprising
a multilayer Group III nitride substrate comprising a first major surface and at least one heterojunction that is capable of supporting a two-dimensional charge gas;
at least one contact comprising a contact trench extending into the multilayer Group III nitride substrate from the first major surface, the contact trench being filled with n-doped Group III nitride material for forming an electrical connection to the two-dimensional charge gas;
at least one dummy trench extending into the multilayer Group III nitride substrate from the first major surface, the dummy trench being partially filled with n-doped Group III nitride material,
wherein the dummy trench has a width B and the contact trench has a width b, wherein B ≥ 1.1b.

2. A semiconductor substrate according to claim 1, wherein the contact trench extends to or through the heterojunction.

3. A semiconductor substrate according to claim 1 or claim 2, wherein the multilayer Group III nitride substrate comprises at least one active device area and at least one non-active area, wherein the at least one contact trench is arranged in the active device area and at least one of the dummy trenches is arranged in the non-active area and/or in the active device area.

4. A semiconductor substrate according to claim 3, wherein
the semiconductor substrate is a semiconductor die having an active device region that is surrounded by an edge termination region that provides the non-device area, or
the semiconductor substrate is a semiconductor wafer with a plurality of component positions that are separated by non-device areas.

5. A semiconductor substrate according to any one of claims 1 to 4, wherein the at least one contact trench has a length that extends parallel to the first surface and the at least one dummy trenches has a length that extends parallel to the first surface, wherein the length of one or more of the dummy trenches extends at an angle α to the length of the contact trench, wherein 0° < α ≤ 90° and/or the length of one or more of the dummy trenches extends parallel to the length of the contact trenches.

6. A semiconductor substrate according to any one of claims 1 to 5, wherein the semiconductor substrate comprises a plurality of dummy trenches and the dummy trenches are arranged in a regular pattern.

7. A semiconductor substrate according to claim 6, wherein the regular pattern comprises a plurality of rows of dummy trenches that are divided into one or more groups, wherein the dummy trenches of a group extend substantially parallel to one another, wherein the dummy trenches of neighbouring groups extend at an angle β to one another, wherein 0° < β ≤ 90°

8. A semiconductor substrate according to any one of claims 1 to 7, wherein the multilayer Group III nitride body comprises at least two heterojunctions arranged in a stack and the contact trench has a depth such that it extends through the at least two heterojunctions.

9. A semiconductor substrate according to any one of claims 1 to 8, wherein the semiconductor substrate comprises two contacts that are spaced apart on the first major surface and a gate electrode that is arranged laterally between the two contacts to form a transistor device.

10. A semiconductor substrate according to any one of claims 1 to 9, further comprising a metallization structure on the first surface that is electrically connected to the at least one contact, wherein the n-doped Group III nitride material in the at least one dummy trench is electrically separate from the metallization structure.

11. A semiconductor device according to claim 10, wherein the metallization structure provides a source pad, a drain pad and a gate pad and the at least one dummy trench is electrically floating.

12. A method of forming a n-doped Group III nitride contact, the method comprising:
forming at least one contact trench and at least one dummy trench in a first major surface of a multilayer Group III nitride substrate comprising at least one heterojunction that is capable of supporting a two-dimensional charge gas, wherein the dummy trench has a width B that is greater than a width b of the contact trench;
growing n-doped Group III nitride material and filling the contact trench to form a contact and partially filling the dummy trench.

13. A method according to claim 12, wherein the spacing between the dummy trench and the contact trench and/or the depth/width ratio of the dummy trench and/or the depth/width ratio of the contact trench is selected such that growth of the Group III nitride on the first major surface is hindered.

14. A method according to claim 12 or claim 13, wherein the contact trench has a depth/width ratio b:w that is at least 2:1 and the dummy trench has a depth/width ratio B/W that is less than 2:1.

15. A method according to one of claims 12 to 14, further comprising:
forming a metallization structure on the first surface that is electrically connected to the at least one contacts,
wherein the n-doped Group III nitride material in the dummy trench is electrically separate from the metallization structure.
